# EUROPÄISCHE PATENTANMELDUNG

(11) **EP 2 648 284 A1**
(43) Veröffentlichungstag der Anmeldung: **09.10.2013**
(21) Anmeldenummer: 12162812.7
(22) Anmeldetag: 02.04.2012
(51) Int. Cl.: H01R 13/50, H01R 9/24

(54) **Frontstecker für eine SPS-Baugruppe**

(71) Anmelder: Siemens Aktiengesellschaft, 80333 München (DE)
(72) Erfinder: Wallner, Lorenz, 90766 Fürth (DE)

(57) **Zusammenfassung**

Die Erfindung betrifft einen Frontstecker (100) für eine SPS-Baugruppe (112), wobei der Frontstecker (100) eine obere (104) und untere (106) Kontaktleiste aufweist, wobei die untere Kontaktleiste (106) an die obere Kontaktleiste (104) zur Überführung der oberen Kontaktleiste zwischen einem offenen und geschlossenen Zustand über ein Scharnier (102) angelenkt ist, wobei im geschlossenen Zustand die Kontakte (108; 120) der oberen (104) und unteren (106) Kontaktleiste elektrischisoliert seitlich zueinander versetzt angeordnet sind und eine Kontaktierung mit Gegenkontakten (110; 114) der über den Frontstecker (100) zu verbindenden SPS-Baugruppe (112) ermöglichen, wobei die Kontaktierung mit den Gegenkontakten (110; 114) zumindest teilweise auf einer der oberen Seite abgewandten Seite der unteren Kontaktleiste (106) ermöglicht wird.

## Beschreibung

### Beschreibung

### Frontstecker für eine SPS-Baugruppe

Die Erfindung betrifft einen Frontstecker für eine SPS-Baugruppe sowie eine SPS-Baugruppe zur Aufnahme eines Frontsteckers.

Speicherprogrammierbare Steuerungen (SPS) sind Vorrichtungen zur Steuerung oder Regelung von Maschinen oder Anlagen. Die hierzu verwendeten Module sind üblicherweise in sogenannten Baugruppen untergebracht, wobei eine Baugruppe als ein in sich geschlossener bestehender Gegenstand definiert ist, welcher selbst wiederum aus einzelnen Unterbaugruppen und Bauteilen bestehen kann. Eine Baugruppe besteht damit als eine Komponente einer Anlage oder eines Automatisierungssystems und dient mit seiner speicherprogrammierbaren Steuerung der Steuerung oder der Regelung der entsprechenden Vorrichtungen und Maschinen dieser Anlage.

Baugruppen sind die Schnittstellen zur industriellen Prozessierung. Ein vielfältiges Baugruppenspektrum ermöglicht eine modulare Anpassung an unterschiedlichste Aufgaben. So unterstützen Baugruppen vielfältige technologische Aufgabenstellungen und bieten umfangreiche Kommunikationsmöglichkeiten.

Zum praktischen Einsatz einer Baugruppe ist es notwendig, dass entsprechende Komponenten der Automatisierungsanlage bzw. des Automatisierungssystems in elektrischer Weise mit der Baugruppe verbunden werden. Zum Beispiel müssen verschiedene Sensoren und Aktoren, die zum Zwecke der Automatisierung einer Anlage benutzt werden, mit den für die Steuerung genutzten Baugruppen verbunden werden.

Der Erfindung liegt die Aufgabe zugrunde, einen verbesserten Frontstecker für eine SPS-Baugruppe und eine verbesserte Baugruppe zur Aufnahme eines Frontsteckers zu schaffen.

Die der Erfindung zugrunde liegenden Aufgaben werden durch die Merkmale der unabhängigen Patentansprüche gelöst. Bevorzugte Ausführungsformen der Erfindung sind in den abhängigen Patentansprüchen angegeben.

Es wird ein Frontstecker für eine SPS-Baugruppe geschaffen, wobei der Frontstecker eine obere und eine untere Kontaktleiste aufweist, wobei die untere Kontaktleiste an die obere Kontaktleiste zur Überführung der oberen Kontaktleiste zwischen einem offenen und geschlossenen Zustand über ein Scharnier angelenkt ist, wobei im geschlossenen Zustand die Kontakte der oberen und unteren Kontaktleiste elektrisch isoliert seitlich zueinander versetzt angeordnet sind und eine Kontaktierung mit Gegenkontakten der über den Frontstecker zu verbindenden SPS-Baugruppe ermöglichen, wobei die Kontaktierung mit den Gegenkontakten zumindest teilweise auf einer der oberen Seite abgewandten Seite der unteren Kontaktleiste ermöglicht wird.

Ausführungsformen der Erfindung könnten den Vorteil haben, dass unter Beibehaltung einer gegebenen Größe der zum Verklemmen der Kabel verwendeten Klemmelemente die Anzahl der möglichen Kontakte signifikant erhöht werden kann. Beispielsweise ist es möglich, durch das seitliche Zueinanderversetzen der Kontakte die Anzahl dieser Kontakte nahezu zu verdoppeln.

Zwar werden dank der zunehmenden Miniaturisierung der Elektronik verwendete Baugruppen bei gleichem Platzverbrauch immer leistungsfähiger, weshalb an eine einzige Baugruppe immer mehr Kabel zur Kommunikation mit den besagten Komponenten der Automatisierungsanlage anzuschließen sind.

Die hierzu verwendeten Schraubklemmen können jedoch nicht beliebig verkleinert werden, da sie ja auf der einen Seite noch von bedienenden Menschen betätigt werden müssen und andererseits auch einen gewissen elektrischen Strom tragen müssen. Im Falle zu kleiner Klemmen können die anzuschließenden Kabel keine großen Querschnitte mehr haben, sodass der zu tragende Strom reduziert werden muss.

Dies bedeutet, dass zwar auf der einen Seite die Anzahl der an eine einzige Baugruppe anzuschließenden Kabel dadurch erhöht werden kann, indem die hierzu verwendeten Klemmen immer weiter verkleinert und zusammengerückt werden. Dies geschieht jedoch auf Kosten der Bedienbarkeit beim Verdrahten bzw. auf Kosten des maximalen Kabeldurchmessers, der noch in die Klemmen eingefügt werden kann. Außerdem müssen von Klemme zu Klemme zur Sicherstellung der elektrischen Isolation gewisse Abstände eingehalten werden. Auch dadurch wird die Anzahl der Klemmen pro Flächeneinheit begrenzt.

Die besagten Ausführungsformen der Erfindung könnten genau hier den Vorteil haben, dass unabhängig von einer Miniaturisierung aller Bauteile die Anzahl der möglichen Kontakte aufgrund deren Verteilung in der oberen und unteren Kontaktleiste signifikant erhöht werden kann.

Dadurch, dass ferner gemäß Ausführungsformen der Erfindung ein Teil der Kontakte an der oberen Kontaktleiste und ein Teil der Kontakte an der unteren Kontaktleiste angeordnet sind und diese jeweilige Kontaktleiste über ein Scharnier zwischen einem offenen und einem geschlossenen Zustand überführbar sind, ist es möglich, im geöffneten Zustand in einfach zugänglicher Weise die entsprechenden Kabel an den jeweiligen Klemmen zu montieren. Im geschlossenen Zustand ist es dann möglich, die elektrische Verbindung zwischen den Kontakten der oberen Kontaktleiste und den Gegenkontakten der SPS-Baugruppe zu ermöglichen. Die elektrische Verbindung zwischen den Kontakten der unteren Kontaktleiste und den entsprechenden Gegenkontakten der SPS-Baugruppe besteht unabhängig vom Öffnungs- oder Schließzustand der oberen Kontaktleiste.

Vorzugsweise sind die Kontakte der oberen Kontaktleiste im offenen Zustand von den Gegenkontakten der SPS-Baugruppe getrennt. Damit ist insbesondere gesichert, dass automatisch im offenen Zustand die obere Kontaktleiste stromlos ist. Dadurch ist eine stromlose Montage von Kabeln an die Kontakte der oberen Kontaktleiste möglich. Selbstverständlich gilt dies nur für Spannungen, welche auch selbst von der SPS-Baugruppe ausgegeben werden.

Vorzugsweise ist weiterhin die Zuführung der Lastspannung der Baugruppe über die obere Kontaktleiste realisiert. Dadurch sind im geöffneten Zustand automatisch alle über diese Lastspannung gespeisten Ausgänge der Baugruppe stromlos, unabhängig davon, ob sich die zugehörigen Kontakte und mit diesen Kontakten verbundenen Kabel auf der oberen oder unteren Kontaktleiste befinden.

Insgesamt wird damit das Problem gelöst, dass die Verdrahtung der Kontakte aus Sicherheitsgründen nur im spannungslosen Zustand erfolgen sollte. Dies wird durch den beschriebenen Mechanismus automatisch gelöst, welcher schon vor einer möglichen Berührung der Kontakte diese spannungslos schaltet. Andere Mechanismen mit dieser Funktionalität, die ein Anwender erst manuell auslösen muss, wie z.B. das vorherige Ausschalten des Netzteils, können aufgrund des mangelnden Komforts nur schwer eine konsequente Nutzung durch die Anwender erreichen.

Es sei an dieser Stelle angemerkt, dass der Frontstecker selbst von der SPS-Baugruppe und damit von den Gegenkontakten in der SPS-Baugruppe abgezogen werden kann, sodass es sogar möglich ist, die Verklemmung oder allgemein Verbindung der Kabel mit den jeweiligen Kontakten der oberen und unteren Kontaktleiste im abgezogenen Zustand in komfortabler Weise durchzuführen. Grundsätzlich kann im Rahmen der vorliegenden Erfindung eine Verklemmung der Kabel mit den Kontakten dergestalt erfolgen, dass zum Beispiel Schraubklemmen oder entsprechende federbehaftete Quetschklemmen hierfür verwendet werden. Es sind jedoch auch andere aus dem Stand der Technik bekannte Verklemmmöglichkeiten möglich, beispielsweise durch Rastverbindungen oder Ähnlichem. Durch den abziehbaren Frontstecker ist es insbesondere auch möglich, eine defekte SPS-Baugruppe auszutauschen, ohne dass alle Kabel von den Klemmen der alten Baugruppe abgeklemmt und bei der neuen Baugruppe aufgeklemmt werden müssten.

Nach einer Ausführungsform der Erfindung handelt es sich bei dem Scharnier um ein exzentrisches Scharnier. Wird hier ein leicht exzentrisches Scharnier verwendet, kann die obere Kontaktleiste nahezu vollständig aufgeklappt werden, ohne mit eventuell benachbarten Baugruppen gleicher Höhe zu kollidieren. So sind außerdem im aufgeklappten Zustand die Kontakte im Deckel besser zugänglich z.B. zur Verklemmung von entsprechenden Kabeln mit den Kontakten.

Nach einer weiteren Ausführungsform der Erfindung ist an der oberen Kontaktleiste an ihrer von der unteren Kontaktleiste abgewandten Seite ein Baugruppenverschluss oder Baugruppendeckel für die SPS-Baugruppe angeordnet. Es wird also durch den Frontstecker der typischerweise für die betroffenen Baugruppen benötigte Verschluss oder Deckel durch den an dem Frontstecker angeordneten Deckel (Baugruppenverschluss/Baugruppendeckel) ersetzt. Anstatt also einen separaten Baugruppenverschluss oder Baugruppendeckel für die SPS-Baugruppe ohne zusätzliche Funktion zu verwenden, ist vorgesehen, auf der Unterseite dieses Deckels die obere Kontaktleiste vorzusehen, sodass sich der Platz, welcher für Kontakte und entsprechende Klemmelemente zur Verfügung steht, verdoppelt. Dieser "Nebeneffekt" von Ausführungsformen der Erfindung ergibt sich auch insbesondere aus der Ausgestaltung des Frontsteckers, bei welcher die Kontakte der oberen Kontaktleiste im offenen Zustand von den Gegenkontakten der SPS-Baugruppe automatisch getrennt sind. Es können damit durch den Frontstecker synergistisch zwei Vorteile auf einmal erzielt werden, nämlich eine vereinfachte, stromlose und damit ungefährliche Kabelmontage im geöffneten Zustand des Frontsteckers bei gleichzeitiger Erhöhung der Gesamtdichte der verwendbaren Kontakte im Fronstecker.

Nach einer Ausführungsform der Erfindung befindet sich zwischen der oberen und unteren Kontaktleiste im geschlossenen Zustand ein Kabelkanal. Zum Beispiel weist der Kabelkanal Schutzwände zur Stabilisierung von zur Kontaktierung der Kontakte benötigten Kabeln auf, wobei die Schutzwände zwischen der oberen und der unteren Kontaktleiste verlaufen. Im geschlossenen Zustand der oberen und unteren Kontaktleiste verlaufen vorzugsweise die Schutzwände nahezu senkrecht zu den Kontaktleisten. Zwischen dem zugeklappten Frontdeckel und der gegebenenfalls durch die Unterseite des Frontdeckels hindurchragende SPS-Baugruppe bildet sich somit ein Hohlraum, der als Kabelkanal dient. Damit die Kabel beim Zuklappen nicht von den Kontakten eingequetscht werden, ist somit vorzugsweise sowohl an der oberen Kontaktleiste als auch alternativ oder zusätzlich an der SPS-Baugruppe selbst eine entsprechende Schutzwand vorgesehen, die verhindert, dass die Kabel aus dem Kabelkanal herausrutschen können.

Es besteht also die Möglichkeit, entsprechende Schutzwände an der SPS-Baugruppe selbst anzuordnen, welche dabei in den Kabelkanal hineinreichen und damit zumindest teilweise in den Frontstecker hineinreichen. Alternativ oder zusätzlich ist es möglich, an der oberen Kontaktleiste eine solche entsprechende Schutzwand oder mehrere Schutzwände anzubringen, wobei im Fall der Kombination von Schutzwänden an der SPS-Baugruppe und an der oberen Kontaktleiste diese Schutzwände übereinander zu liegen kommen, wenn die obere und untere Kontaktleiste im geschlossenen Zustand befindlich sind.

Nach einer weiteren Ausführungsform der Erfindung weist die untere Kontaktleiste Aussparungen zur Aufnahme von Zwischensteckern auf, wobei die Zwischenstecker eine Verlängerung der Kontakte der oberen Kontaktleiste bilden und/oder wobei die Zwischenstecker Teil der Gegenkontakte der über den Frontstecker zu verbindenden SPS-Baugruppe sind, wobei die Aussparungen ferner zur Ermöglichung einer Verbindung der Kontakte der oberen Kontaktleiste mit den Zwischensteckern ausgebildet sind. Somit gibt es zwei Möglichkeiten, welche gegebenenfalls auch miteinander kombiniert werden können. In Variante 1 weisen die Kontakte der oberen Kontaktleiste "lange" Zwischenstecker auf, welche durch Hindurchragen durch die Aussparungen der unteren Kontaktleiste einen direkten Kontakt mit den Gegenkontakten der SPS-Baugruppe herstellen können. In Variante 2 hingegen weist die SPS-Baugruppe selbst lange Zwischenstecker auf, welche fest mit den Gegenkontakten der SPS-Baugruppe verbunden sind und welche durch die Aussparungen der unteren Kontaktleiste hindurchragen können.

Diese Zwischenstecker der SPS-Baugruppe stellen damit wiederum direkt den Kontakt zu den Kontakten der oberen Kontaktleiste her. In allen Fällen stellen also die genannten Zwischenstecker einen Kontakt direkt zu den Gegenkontakten der Leiterplatte der SPS-Baugruppe her, ohne den Umweg über entsprechende Kontakte am Frontstecker. Somit haben sowohl die Kontakte der unteren Kontaktleiste als auch die Kontakte der oberen Kontaktleiste nur genau einen einzigen Übergangspunkt zu den jeweiligen Gegenkontakten der SPS-Baugruppe.

Nach einer Ausführungsform der Erfindung greifen die Zwischenkontakte und die Kontakte der unteren Kontaktleiste ineinander. Beispielsweise ist es möglich, entsprechende Zwischenkontakte und Kontakte der unteren Kontaktleiste im geschlossenen Zustand konzentrisch zueinander anzuordnen.

Nach einer Ausführungsform der Erfindung sind die Kontakte der oberen Kontaktleiste und die Kontakte der Kontaktleiste räumlich in einer Linie abwechselnd hintereinander angeordnet zur Bildung der seitlich zueinander versetzten Anordnung der Kontakte.

Nach einer Ausführungsform der Erfindung sind an den Kontakten der oberen Kontaktleiste obere Klemmmittel angeordnet, wobei die oberen Klemmmittel zur Kontaktierung der Kontakte der oberen Kontaktleiste mit hierzu benötigten Kabeln ausgebildet sind. Ferner sind an den Kontakten der unteren Kontaktleiste untere Klemmmittel angeordnet, wobei die unteren Klemmmittel zur Kontaktierung der Kontakte der unteren Kontaktleiste mit hierzu benötigten Kabeln ausgebildet sind. Im geschlossenen Zustand der oberen und unteren Kontaktleiste sind dabei die oberen Klemmmittel und die unteren Klemmmittel in einer Linie übereinander elektrisch isoliert angeordnet. Damit ist in optimaler Weise der zur Verfügung stehende Platz, der für die Klemmmittel zur Verfügung steht, ausgefüllt und die Anzahl der unterbringbaren Klemmen wird verdoppelt.

Nach einer weiteren Ausführungsform der Erfindung haben die Kontakte der oberen Kontaktleiste im geöffneten Zustand keinen Kontakt zu den Gegenkontakten der SPS-Baugruppe. Diese Klemmen könnten zum Beispiel bevorzugt mit Ausgängen der Baugruppe belegt werden, sodass diese automatisch beim Anbringen der entsprechenden Kabel bei geöffnetem Deckel stromlos sind. Dadurch wird beispielsweise eine Verletzungsgefahr von entsprechend die Frontstecker montierenden Personen minimiert. Insbesondere ist es auch möglich, eine Versorgungsspannung oder Lastspannung der SPS-Baugruppe ausschließlich über die Kontakte der oberen Kontaktleiste zuführen. Damit sind im geöffneten Zustand mangels Lastspannung automatisch alle Ausgänge der Baugruppe stromlos.

In einem weiteren Aspekt betrifft die Erfindung eine SPS-Baugruppe zur Aufnahme eines Frontsteckers, wie obig beschrieben.

Ein Automatisierungsnetzwerk mit Automatisierungskomponenten, gesteuert durch SPS-Baugruppen, kann im Rahmen der vorliegenden Beschreibung z.B. als industrielles Automatisierungsnetzwerk ausgebildet sein. Solche industriellen Automatisierungsnetzwerke können z.B. zur Steuerung und/oder Regelung von industriellen Anlagen (z.B. Produktionsanlagen, Förderanlagen usw.), Maschinen und/oder Geräten ausgebildet, eingerichtet

und/oder vorgesehen sein. Insbesondere können Automatisierungsnetzwerke bzw. industrielle Automatisierungsnetzwerke Echzeit-Kommunikationsprotokolle (z.B. Profinet, Profibus, Real-Time-Ethernet)zur Kommunikation zumindest zwischen den an den Steuerungs- und/oder Regelungsaufgaben beteiligten Komponenten (z.B. zwischen den Steuerungseinheiten und den zu steuernden Anlagen und/oder Maschinen) aufweisen. Die sichere Übertragung von Daten über Speichermedien ist ebenfalls abgedeckt.

Weiterhin kann neben einem Echtzeit-Kommunikationsprotokoll aber auch noch mindestens ein weiteres Kommunikationsprotokoll (das z.B. nicht echtzeitfähig zu sein braucht) in dem Automatisierungsnetzwerk bzw. industriellen Automatisierungsnetzwerk vorgesehen sein, z.B. zum Überwachen, Einrichten, Umprogrammieren und/oder Umparametrieren einer oder mehrerer Steuerungseinheiten im Automatisierungsnetzwerk.

Ein Automatisierungsnetzwerk kann z.B. drahtgebundene Kommunikationskomponenten und/oder drahtlose Kommunikationskomponenten umfassen. Außerdem kann ein Automatisierungsnetzwerk zumindest eine Automatisierungseinrichtung umfassen.

Ein Automatisierungsnetzwerk umfasst mehrere Sensoren und Aktuatoren. Die Aktuatoren und Sensoren werden von zumindest einer Steuerungseinrichtung gesteuert. Die Aktuatoren, die Sensoren und die zumindest eine Steuerungseinrichtung tauschen Daten miteinander aus. Zum Datenaustausch wird ein Automatisierungsprotokoll verwendet. Die zumindest eine Steuerungseinrichtung steuert die Aktuatoren, die Sensoren und den Datenaustausch so, dass ein maschineller Fertigungsprozess abläuft, in dem z.B. ein Produkt hergestellt wird.

Eine industrielle Automatisierungseinrichtung kann z.B. eine speicherprogrammierbare (SPS) Steuerung, ein Modul oder Teil einer speicherprogrammierbaren Steuerung, eine in einem Computer oder PC integrierte speicherprogrammierbare Steuerung sowie entsprechende Feldgeräte, Sensoren und/oder Aktoren, Ein- und/oder Ausgabegeräte oder Ähnliches zum Anschluss an einer speicherprogrammierbare Steuerung sein oder solche umfassen.

Als Automatisierungsprotokoll im Sinne der vorliegenden Erfindung wird jede Art von Protokoll verstanden, das zur Kommunikation mit Automatisierungs-Einrichtungen gemäß der vorliegenden Beschreibung vorgesehen, geeignet und/oder eingerichtet ist. Solche Automatisierungsprotokolle können beispielsweise das Profi-Bus-Protokoll (z. B. gemäß IEC 61158/EN50170), ein Profi-Bus-DP-Protokoll, ein Profi-Bus-PA-Protokoll, ein Profi-Net-Protokoll, ein Profi-Net-IO-Protokoll, ein Protokoll gemäß AS-Interface, ein Protokoll gemäß IO-Link, ein KNX-Protokoll, ein Protokoll gemäß einer Mehrpunkt-Schnittstelle (Multipoint-Interface, MPI), ein Protokoll für eine Punkt-zu-Punkt-Kopplung (Point-to-Point, PtP), ein Protokoll gemäß den Spezifikationen der S7-Kommunikation (welches beispielsweise zur Kommunikation von speicherprogrammierbaren Steuerungen der Firma Siemens vorgesehen und eingerichtet ist) oder auch ein Industrial-Ethernet-Protokoll oder Real-Time-Ethernet-Protokoll bzw. weitere spezifische Protokolle für die Kommunikation mit Automatisierungsgeräten sein. Als Automatisierungsprotokoll im Sinne der vorliegenden Beschreibung können auch beliebige Kombinationen der vorgenannten Protokolle vorgesehen sein.

Im Folgenden werden bevorzugte Ausführungsformen der Erfindung anhand der Zeichnungen erläutert. Es zeigen:
- Figur 1: eine Seitenansicht eines auf einer SPS-Baugruppe befindlichen Frontsteckers,
- Figur 2: eine Querschnittsansicht durch einen Frontstecker bei geschlossenem Frontdeckel,
- Figur 3: eine Aufsicht auf einen Frontstecker im eingebauten Zustand in einer SPS-Baugruppe.

Im Folgenden werden einander ähnliche Elemente mit den gleichen Bezugszeichen gekennzeichnet.

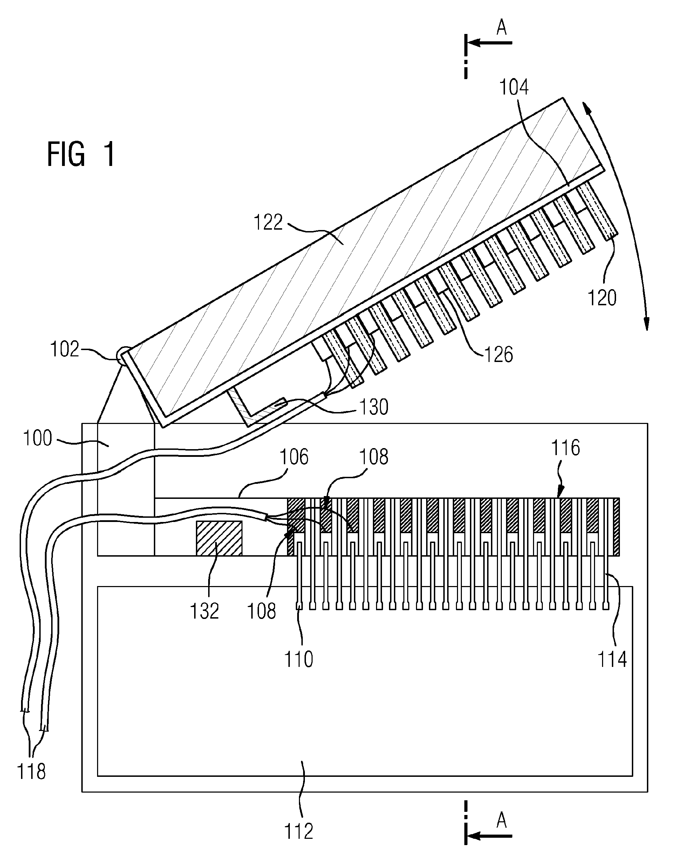

Die Figur 1 zeigt eine schematische Ansicht eines Frontsteckers 100 für eine SPS-Baugruppe in einer seitlichen Ansicht. Der Frontstecker 100 weist eine obere Kontaktleiste 104 und eine untere Kontaktleiste 106 auf, welche über ein exzentrisches Scharnier 102 aneinander angelenkt sind. Durch das Scharnier 102 ist die obere Kontaktleiste 104 relativ zur unteren Kontaktleiste 106 schwenkbar und damit zwischen einem geöffneten und einem geschlossenen Zustand bewegbar.

Der Frontstecker 100 ist mit seiner unteren Kontaktleiste 106 in die SPS-Baugruppe 112 eingesetzt. Die SPS-Baugruppe 112 weist dabei elektrische Gegenkontakte 110 und 114 auf. Durch den eingesetzten Zustand greifen dabei die Gegenkontakte 110 in Kontakte 108 der unteren Kontaktleiste 106 ein. Anstatt eines Ineinandergreifens der Kontakte 108 und 110 ist es auch möglich, dass die beiden Kontakte lediglich flächig aufeinander zu liegen kommen.

Die untere Kontaktleiste 106 weist Aussparungen 116 auf, durch welche die Gegenkontakte 114 der SPS-Baugruppe 112 hindurchragen. Die Gegenkontakte 114 dienen dabei der Kontaktierung mit Zwischensteckern 120 der oberen Kontaktleiste 104. In der Ausführungsform der Figur 1 sind dabei die Zwischenstecker 120 mit entsprechenden Kontakten der oberen Kontaktleiste 104 identisch. Um nun Kabel 118 mit den entsprechenden Kontakten 108 bzw. 120 elektrisch zu verbinden, sind sogenannte Kabelterminals vorgesehen. Diese Kabelterminals können beispielsweise Schraubmechanismen aufweisen, um die Kabel 118 mit den Terminals 108 bzw. im Falle der oberen Kontaktleiste 104 mit Terminals 126 zu verklemmen. Die Kabelterminals 126 der oberen Kontaktleiste 104 sind in elektrischem Kontakt mit den jeweils zugeordneten Kontakten bzw. Zwischensteckern 120. Durch das Zuklappen des Frontsteckers 100 werden die Zwischenstecker 120 mit den Gegenkontakten 114 der SPS-Baugruppe 112 elektrisch verbunden. Beispielsweise können die Zwischenstecker 120 entsprechende Aussparungen aufweisen, in welche beim Zuklappen die Gegenkontakte 114 innerhalb der Aussparung 116 eingreifen. Allerdings ist es auch möglich, dass beim Zusammenklappen lediglich die Oberseiten der Zwischenkontakte 120 und der jeweiligen Gegenkontakte 114 aufeinander zu liegen kommen. Insgesamt muss lediglich ein elektrischer Kontakt zwischen den Zwischensteckern 120 und den Gegenkontakten 114 hergestellt werden.

Die Kontakte 120 und 108 sind im geschlossenen Zustand der oberen und unteren Kontaktleiste elektrisch isoliert seitlich zueinander versetzt angeordnet. In der Figur 1 ist ersichtlich, dass von links nach rechts gesehen die Kontakte der oberen Kontaktleiste und die Kontakte der unteren Kontaktleiste abwechselnd sequenziell zueinander angeordnet sind. Die jeweiligen Kontakte sind also räumlich in einer Linie abwechselnd hintereinander angeordnet zur Bildung der seitlich zueinander versetzten Anordnung der Kontakte 120 bzw. 108.

An der oberen Kontaktleiste 104 ist ferner ein Baugruppendeckel oder Baugruppenverschluss 122 angeordnet, welcher im geschlossenen Zustand die SPS-Baugruppe 112 abdeckt. Durch diese Abdeckung ist sowohl die SPS-Baugruppe als auch der Frontstecker selbst von Staub und anderen Umwelteinflüssen geschützt. Es sei angemerkt, dass der Baugruppendeckel auch durch die obere Kontaktleiste 104 selbst gebildet werden kann, so dass das Vorsehen einer extra Deckelkomponente 122 entfallen kann.

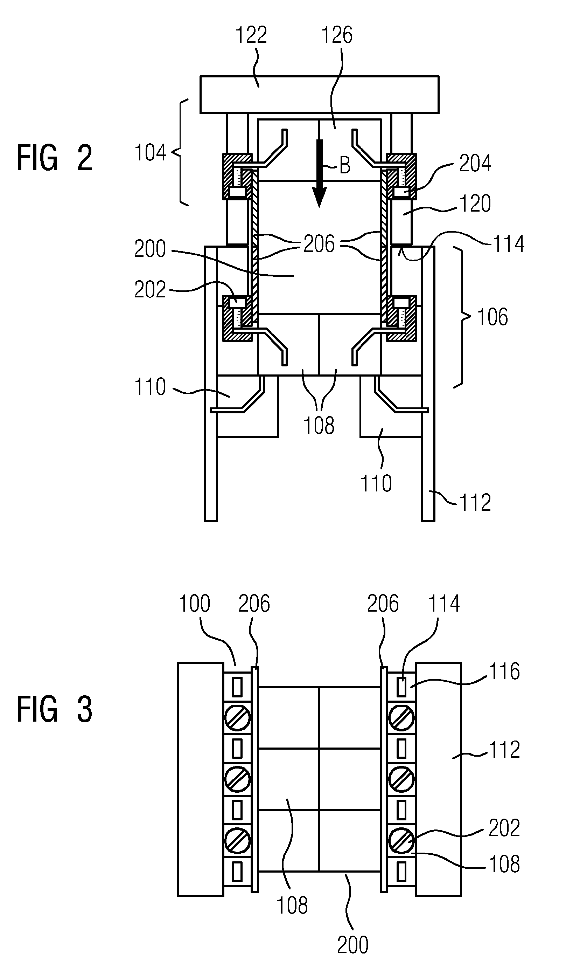

Die Figur 2 zeigt eine Querschnittsansicht durch den Frontstecker 100 bei geschlossenem Frontdeckel 122, das heißt bei geschlossenem Baugruppenverschluss oder Baugruppendeckel, wobei in diesem Fall die obere Kontaktleiste 104 und die untere Kontaktleiste 106 über das Scharnier 102 übereinander zu liegen kommen. Die Ansicht entspricht dabei einer Querschnittsansicht durch den in Figur 1 mit dem Buchstaben A gezeigte Ebene.

Deutlich sichtbar sind hier für die obere Kontaktleiste 104 die Kabelterminals 126, an welche über entsprechende Schrauben 204 in Figur 2 nicht näher ersichtliche Kabel verklemmt werden können. Mit dem Kabelterminal 126 in elektrischem Kontakt stehend sind unterhalb der Schraubverbindungen 204 die Zwischenstecker 120 angeordnet. Die Zwischenstecker 120 liegen dabei flächig auf den entsprechenden Gegenkontakten 114 der SPS-Baugruppe 112 auf.

Analog liegen die Gegenkontakte 110 auf den entsprechenden Kontakten 108 der unteren Kontaktleiste 106 auf, wobei die unteren Kontakte 108 auch gleichzeitig als Kabelterminals dienen. Die hier anzuschließenden und in Figur 2 nicht näher ersichtlichen Kabel können wieder über entsprechende Schraubverbindungen 202 an den Terminals 108 befestigt werden.

Im geschlossenen Zustand bildet sich zwischen der oberen Kontaktleiste 104 und der unteren Kontaktleiste 112 ein Kabelkanal 200, welcher Platz zum Verlegen der mit den Terminals 108 bzw. 126 verbundenen Kabel bietet. Damit diese Kabel jedoch nicht beim Zuklappen beispielsweise von den Zwischensteckern 120 gequetscht werden, befinden sich sowohl an der oberen Kontaktleiste 104 als auch an der SPS-Baugruppe 112 entsprechende Schutzwände 206. Durch diese Schutzwände wird letztlich der Kabelkanal 200 definiert.

Wie aus den Figuren 1 und 2 klar ist, wird aufgrund der günstigen Anordnung der Kabelterminals 126 bzw. 108 der Platz für die Platzierung verdoppelt. Damit ist die Möglichkeit gegeben, mehr oder insgesamt größere Klemmen beim gleichen Platzverbrauch zu verwenden. Die Klemmen 126 haben im geöffneten Zustand des Deckels keinen Kontakt zur Baugruppe 112. Diese Klemmen könnten zum Beispiel bevorzugt mit Ausgängen der Baugruppe belegt werden, sodass diese automatisch beim Anbringen der entsprechenden Kabel bei geöffnetem Deckel stromlos sind. Dadurch wird beispielsweise eine Verletzungsgefahr von entsprechend die Frontstecker montierenden Personen minimiert.

Sowohl bei den Kontakten 108 als auch bei den Kontakten 120 wird der Kontakt zur entsprechenden Leiterplatte der SPS-Baugruppe 112 nur über einen einzigen steckbaren Kontakt hergestellt, das heißt der Weg von der jeweiligen Klemme zur Leiterplatte ist relativ kurz. Hinsichtlich der elektrischen Eigenschaften wie beispielsweise deren Übergangswiderstände sind also die Kontakte 120 und 108 als identisch anzusehen.

Mit dem in Figuren 1 und 2 gezeigten Frontstecker können auch bestehende Baugruppen problemlos aufgerüstet werden. Der gegebenenfalls bestehende Deckel von bestehenden Baugruppen müsste dann lediglich durch den gesamten Frontstecker ersetzt werden.

Möglich ist auch noch eine Verwendung einer automatischen Kabelklemme beim Schließen des Deckels zur Zugentlastung der in Figur 1 gezeigten Kabel 118. Der Mechanismus der Kabelklemme ist dabei in Figur 1 mit dem Bezugszeichen 130 gekennzeichnet. Beim Schließen der oberen Kontaktleiste 104 wird die stempelförmige Kabelklemme 130 auf die Kabel 118 aufgepresst. Dadurch werden die Kabel entweder direkt an die untere Kontaktleiste 106 im geschlossenen Zustand angepresst. Alternativ kann der in Figur 1 ersichtliche Auflageblock (Anschlag) 132 Verwendung finden, auf welchen die Kabel über die Kabelklemme 130 aufgepresst wird. Hat der Block 132 z.B. eine V-förmige oder U-Förmige Aussparung, kann in dieser Aussparung automatisch beim Schließen der oberen Kontaktleiste eine Zentrierung der Kabel 118 im Kabelkanal bei gleichzeitiger Fixierung (Verklemmung) der Kabel gegen unbeabsichtigtes Herausreißen gewährleistet werden. Vorzugsweise kann ein geeigneter Arretiermechanismus vorgesehen werden, welcher die obere und unter Kontaktleiste im geschlossenen Zustand auch geschlossen hält. Hier könnten z.B. entsprechende Rastmittel zwischen der oberen und unteren Kontaktleiste zum Einsatz kommen.

Durch die Kabelklemme 130 ergibt sich damit eine Zugentlastung der Kabel 118. Es sei angemerkt, dass es unerheblich ist, ob die Kabelklemme 130 an der oberen oder an der unteren Kontaktleiste angeordnet ist.

Da die obere Kontaktleiste 104 eine längliche Form hat, ergibt sich automatisch ein relativ großer Hebel, mit welchem bequem eine sinnvolle Kraft übertragen werden kann, um die Kabel 118 festzuklemmen.

An der Unterseite der oberen Kontaktleiste befindet sich dazu ein Stempel, der auf einen Gegenanschlag, z.B. ein Plättchen drückt, welches sich durch entsprechende Schienen nur vertikal in Ersteckungsrichtung der oberen und unteren Kontaktleiste bewegen kann. Dadurch wird bei einem Schließvorgang der oberen Kontaktleiste das Kabel gegen einen Anschlag gedrückt, so dass das Kabel sicher arretiert wird. Der Stempel bewegt sich mit der oberen Kontaktleiste z.B. bei deren Schließen auf einer kreisförmigen Bahn. Damit ergibt sich beim Bewegungsvorgang (Öffnen oder Schließen) neben einer vertikalen Komponente, welche den eigentlichen Anpressdruck bewirkt, auch eine horizontale Komponente der Bewegung. Durch diese horizontale Komponente könnte das Kabel aufgrund von Zugkräften beschädigt werden. Durch den horizontal bewegbaren Gegenanschlag ist gewährleistet, dass auf das Kabel wirklich nur die vertikale Komponente der Bewegung wirkt. Es sei angemerkt, dass dies selbstverständlich unabhängig von einer speziellen Anordnung der Kontakte und des Vorhandenseins des Deckels ist.

Vorzugsweise ist der Gegenanschlag bezüglich seiner vertikalen Beweglichkeit federbeaufschlagt. Dadurch nimmt der Gegenanschlag beim Öffnen der oberen Kontaktleiste automatisch eine Initialposition ein, aus welcher er dann beim Schließen der oberen Kontaktleiste vertikal reversibel verschoben wird. Vorzugsweise sind an Kabelklemme 130 und/oder Anschlag 132 elastische Materialien wie z.B. Moosgummi oder Schaumstoff angebracht, um die Kraft auf die Kabel 118 besser zu verteilen.

Es sei angemerkt, dass die obere Kontaktleiste vorzugsweise abnehmbar sein sollte, so dass es möglich ist, die Kabel 118 bequem einzulegen bzw. zu entfernen.

Für das Wieder-Einbringen der oberen Kontaktleiste sollte es dabei verschiedene Aufnahmepunkte für das Scharnier geben, über welches die obere Kontaktleiste an die untere Kontaktleiste angelenkt ist. Der Abstand der oberen von der unteren Kontaktleiste und damit des Stempels von dem Plättchen wird dadurch variabel einstellbar. Damit können insbesondere Kabel unterschiedlicher Dicke arretiert werden.

Es ergibt sich hier also eine Doppel-Nutzung der oberen Kontaktleiste, einerseits als Deckel der Baugruppe und andererseits als Hebel für den Klemm-Mechanismus. Der Vorteil liegt darin, dass sich der Vorgang des Arretieren der Kabel zwanglos in den ohnehin vorhandenen Ablauf beim Verbinden der Kabel mit der Baugruppe einfügt: Zunächst wird die obere Kontaktleiste aufgeklappt, um Zugriff auf die Kabelterminals 108 bzw. 126 zu erhalten. Hierbei werden die Kabel von der Klemme 130 automatisch freigegeben. Danach werden die Kabel nach Wunsch mit den Terminals verbunden. Wenn dann der Deckel geschlossen wird, indem die obere Kontaktleiste heruntergeklappt wird, werden die Kabel wieder automatisch arretiert. Insgesamt erhöht dies also den Komfort beim Arbeiten mit der Baugruppe, da keine zusätzlichen Arbeitsmittel (z.B. Kabelbinder) zum Arretieren der Kabel benötigt werden.

Die Figur 3 zeigt eine Aufsicht auf den Frontstecker 100 entlang der Schnittebene B der Figur 2. Aus Darstellungsgründen wurde hierbei der Deckel 122 und die Kontaktleiste 104 mit den entsprechenden Kontakten weggelassen.

Ersichtlich sind nun die Kabelterminals bzw. Kontakte 108, an welche über die Schrauben 202 entsprechende Kabel befestigt werden können. Seitlich an den Schraubverbindungen 202 entlang geführt sind wiederum die Schutzwände 206, welche einander gegenüberliegend einen Kanal 200 für aufzunehmende Kabel bilden. Ferner ersichtlich sind die Aussparungen 116 der unteren Kontaktleiste 106, wobei durch diese Aussparungen 116 die Gegenkontakte 114 der SPS-Baugruppe 112 hindurchragen. Im geschlossenen Zustand des Frontdeckels kann damit eine Kontaktierung zwischen den Gegenkontakten 114 und den Zwischenkontakten 120 stattfinden. Ebenfalls im geschlossenen Zustand liegen dann, wie in Figur 2 ersichtlich, die Kabelterminals 126 bzw. 108 und auch die entsprechenden Schraubverbindungen 204 bzw. 202 elektrisch isoliert in einer Linie übereinander. Insgesamt liegen also die durch die Kabelterminals 126 und die Schrauben 204 bzw. die Kabelterminals 108 und die Schrauben 202 gebildeten Klemmen in einer Linie übereinander.

## Patentansprüche

1. Frontstecker (100) für eine SPS-Baugruppe (112), wobei der Frontstecker (100) eine obere (104) und untere (106) Kontaktleiste aufweist, wobei die untere Kontaktleiste (106) an die obere Kontaktleiste (104) zur Überführung der oberen Kontaktleiste zwischen einem offenen und geschlossenen Zustand über ein Scharnier (102) angelenkt ist, wobei im geschlossenen Zustand die Kontakte (108; 120) der oberen (104) und unteren (106) Kontaktleiste elektrisch-isoliert seitlich zueinander versetzt angeordnet sind und eine Kontaktierung mit Gegenkontakten (110; 114) der über den Frontstecker (100) zu verbindenden SPS-Baugruppe (112) ermöglichen, wobei die Kontaktierung mit den Gegenkontakten (110; 114) zumindest teilweise auf einer der oberen Seite abgewandten Seite der unteren Kontaktleiste (106) ermöglicht wird.

2. Frontstecker (100) nach Anspruch 1, wobei es sich bei dem Scharnier (102) um ein exzentrisches Scharnier (102) handelt.

3. Frontstecker (100) nach einem der vorigen Ansprüche, wobei an der oberen Kontaktleiste (104) an ihrer von der unteren Kontaktleiste abgewandten Seite ein Baugruppenverschluss oder Baugruppendeckel (122) für die SPS-Baugruppe (112) angeordnet ist.

4. Frontstecker (100) nach einem der vorigen Ansprüche, wobei sich zwischen der oberen (104) und unter Kontaktleiste (106) in geschlossenem Zustand ein Kabelkanal (200) befindet.

5. Frontstecker (100) nach Anspruch 4, wobei der Kabelkanal (200) Schutzwände (206) zur Stabilisierung von zur Kontaktierung der Kontakte benötigten Kabeln aufweist, wobei die Schutzwände (206) zwischen der oberen und der unteren Kontaktleiste verlaufen.

6. Frontstecker (100) nach einem der vorigen Ansprüche, wobei die untere Kontaktleiste (106) Aussparungen (116) zur Aufnahme von Zwischensteckern aufweist, wobei die Zwischenstecker (120) eine Verlängerung der Kontakte der oberen Kontaktleiste bilden und/oder wobei die Zwischenstecker Teil der Gegenkontakte der über den Frontstecker (100) zu verbindenden SPS-Baugruppe (112) sind, wobei die Aussparungen (116) ferner zur Ermöglichung einer Verbindung der Kontakte der oberen Kontaktleiste mit den Zwischensteckern ausgebildet sind.

7. Frontstecker (100) nach Anspruch 6, wobei die Zwischenstecker (120) und die Kontakte (108) der unteren Kontaktleiste (106) ineinandergreifen.

8. Frontstecker (100) nach einem der vorigen Ansprüche, wobei die Kontakte (120) der oberen Kontaktleiste (104) und die Kontakte (108) der unteren Kontaktleiste (106) räumlich in einer Linie abwechselnd hintereinander angeordnet sind zur Bildung der seitlich zueinander versetzten Anordnung der Kontakte.

9. Frontstecker (100) nach einem der vorigen Ansprüche, wobei
- an den Kontakten der oberen Kontaktleiste obere Klemmittel (204) angeordnet sind, wobei die oberen Klemmittel (204) zur Kontaktierung der Kontakte (120) der obere Kontaktleiste (104) mit hierzu benötigten Kabeln (118) ausgebildet sind;
- an den Kontakten (108) der unteren Kontaktleiste (106) untere Klemmittel (202) angeordnet sind, wobei die unteren Klemmittel (202) zur Kontaktierung der Kontakte (108) der unteren Kontaktleiste mit hierzu benötigten Kabeln (118) ausgebildet sind;
- im geschlossenen Zustand der oberen (104) und unteren (106) Kontaktleiste die oberen Klemmittel (204) und die unteren Klemmittel (202) in einer Linie übereinander elektrisch-isoliert angeordnet sind.

10. Frontstecker (100) nach einem der vorigen Ansprüche, wobei die obere Kontaktleiste (104) von der unteren Kontaktleiste (106) reversibel abnehmbar ist.

11. SPS-Baugruppe (112) zur Aufnahme eines Frontsteckers (100) gemäß einem der vorigen Ansprüche.
